Europäisches Patentamt

(19) European Patent Office

Office européen des brevets

(11) Publication number: **0 024 436**
**B1**

(12) **EUROPEAN PATENT SPECIFICATION**

(45) Date of publication of patent specification: **11.09.85**

(21) Application number: **80900438.5**

(22) Date of filing: **27.02.80**

(86) International application number:
**PCT/JP80/00031**

(87) International publication number:
**WO 80/01854 04.09.80 Gazette 80/20**

(51) Int. Cl.⁴: **G 11 C 7/00, G 11 C 17/00,**
**G 06 K 19/00, G 05 B 19/00**

(54) **SEQUENCE CONTROL DATA CONVERSION APPARATUS.**

(30) Priority: **01.03.79 JP 22533/79**

(43) Date of publication of application:
**11.03.81 Bulletin 81/10**

(45) Publication of the grant of the patent:
**11.09.85 Bulletin 85/37**

(84) Designated Contracting States:
**CH DE FR NL SE**

(56) References cited:
**DE-A-2 834 630**
**FR-A-2 356 984**
**JP-A-52 146 134**
**JP-U-49 090 024**
**JP-U-52 037 426**
**US-A-3 798 612**

**FUNKSCHAU 1979, January 1, no. 1, Munich,**
**DE, ECKART MÄRKEL: "Eprom-**
**Programmiergerät 1. Teil", pages 49-53**
**FUNKSCHAU 1979, "Eprom-Programmiergerät**
**2. Teil", page 110**

(73) Proprietor: **KUZE, Yoshikazu**
**31-3 Higashi Magome 1-chome**
**Ohta-Ku, Tokyo143 (JP)**

(72) Inventor: **KUZE, Yoshikazu**
**31-3 Higashi Magome 1-chome**
**Ohta-Ku, Tokyo143 (JP)**

(74) Representative: **Wood, Anthony Charles et al**
**c/o MICHAEL BURNSIDE & PARTNERS 2**
**Serjeants' Inn Fleet Street**
**London EC4Y 1HL (GB)**

(56) References cited:
**Electronics, vol. 22, no. 3, (1977-3-1, K.K.**
**Ohm-sha Hakko), Suzuki Akihiko "PROM**
**Kakikomiki", p. 253-258**
**Mitsubishi Denki Giho, vol. 4P, no. 4, (1975-4-**
**25, Mitsubishi Denki Gihosha Hakko), Takeuchi**
**Tetsu and one other"FPROM Kakikomi Sochi",**
**P345-349**

Courier Press, Leamington Spa, England.

## Description

The present invention relates to apparatus operable to convert a physical representation of sequence control data from the form of a marked program sheet into the form of an electronic memory having said data written therein and capable of subsequent electronic read-out to control a sequence of operations.

My prior German specification DE—A— 2 834 630 describes such apparatus comprising:

a sheet reading device capable of reading an elongate transparent program sheet movable in said device and bearing a series of write clock marks a plurality of data lines and a read/write control line which are formed of opaque material and are arranged in the longitudinal direction of said sheet;

said sheet reading device comprising:

means for passing said sheet along a path in the device;

a plurality of light-emitting elements disposed in the direction lateral to the direction of movement of the sheet at the entrance of said path;

a plurality of light-receiving elements each of which corresponds to a respective one of the light-emitting elements and arranged to generate write clock pulses, data outputs and a read/write signal when light from the corresponding light emitting element is interrupted by the respective write clock marks, data lines and read/write control line;

a RAM for memorising said data in synchronism with said write clock pulses;

a first binary counter for counting said write clock pulses and for addressing said RAM;

a second binary counter for generating read clock pulses in response to pulses from an oscillator;

first gate means responsive to one mode of said read/write signal to condition said RAM into its write-in state and responsive to the other mode of said read/write signal to change the condition of said RAM into its read-out state;

second gate means responsive to said one mode of said read/write signal effective to enable the first binary counter and to inhibit said second binary counter and to condition said RAM into an enable state; and

third gate means for generating a signal for stopping the sheet reading operation when the count of said first binary counter reaches a predetermined number;

whereby data carried by said program sheet is written into said RAM while the read/write signal is in said one-mode during passage of the program sheet through said sheet reading device.

In that prior case the apparatus constituted a sequence controller having both writing means, for writing the data into the electronic memory from the program sheet, and reading means for reading out the data directly from that electronic memory for controlling the sequence of operations.

The present invention is based on an appreciation that such a conventional sequence controller having both a writing means and a reading means is unnecessarily expensive because, in practice, it is often used only for reading out the data for control purposes after the initial writing in of the data from a program sheet.

An object of the present invention is to provide a practical realisation stemming from the above appreciation, i.e. to provide such apparatus having basically only the write-in function.

Accordingly, the present invention provides apparatus as described above from my prior German case DE—A—2 834 630 characterised by:

a connector for detachably connecting an EPROM to said apparatus, said connector having terminals (D) for electrically connecting said EPROM to said RAM to permit transfer of said written-in data from said RAM into said connected EPROM;

means for controlling energisation of a said connected EPROM to permit the EPROM to memorise data read out from said RAM;

said first binary counter being adapted also to address a said connected EPROM;

said second binary counter being adapted also to generate control pulses, in response to pulses from said oscillator, for controlling acceptance by said EPROM of data transferring thereto upon read-out from said RAM in response to said read clock pulses; and

said second gate means also being responsive to said other mode of said read/write signal to enable said second binary counter to generate said read clock pulses and said control pulses;

whereby sequence control data written into said RAM from said program sheet is automatically transferred into said connected EPROM when the read/write signal changes from said one mode to said other mode.

It is known in the art *per se* how to read data from one memory to another memory, for example as shown in US—A—3 798 612 and in articles in Funkschau of 5th January 1979 at pages 49—53 and of 19th January 1979 at page 110.

For convenience of reference, apparatus according to the present invention will be referred to hereinafter simply as a write-only sequence controller.

It will be appreciated that the present invention has provided an effective write-only sequence controller. The write-only sequence controller is provided to write data into the detachable read-only memory (EPROM), and a read-only sequence controller may then be provided with that EPROM to produce an output of sequence control data from that EPROM.

Since data may be written in a plurality of EPROM's by one write-only sequence controller, an economical manner of controlling a sequence of operations has been provided.

Further, the conventional sequence controller is complicated in order to deal with a great variety of control situations and a skilled person is necessary for programming and modifying the data. In addition, the handling operation of the system is complicated, a plurality of handling operations being required. For example, in order to program the data of 100 words×8 bits, key switches must be operated at least 200 times.

The present invention permits provision of a write-only sequence controller in which data programming and modifications are very simple and easy for anybody having no special technical knowledge, and consequently secrets of the programming and modification can be maintained.

A write-only sequence controller of the present invention may be made into a light-weight device having a weight of 450 grams and into a compact size. Thus, an economical controller may be provided for automating machines and for energy saving.

Embodiments of the invention will now be described, by way of example, with reference to the accompanying drawings, in which:—

Figure 1 shows a transparent program sheet for a write-only sequence controller according to the present invention;

Figure 2 shows a time chart formed by opaque tape attached to the transparent program sheet;

Figure 3 shows a front view of the write-only sequence controller;

Figure 4 shows a back view of the write-only sequence controller;

Figure 5 shows a transverse cross-sectional view of the write-only sequence controller;

Figure 6 is a perspective view of the write-only sequence controller;

Figure 7 shows a circuit of a photo-electric switching array of a sheet reader;

Figure 8 shows a circuit of the write-only sequence controller using an EPROM operated by three power supply sources;

Figure 9 is a timing diagram of program pulses;

Figure 10 shows another embodiment of the program pulse generator;

Figure 11 shows a timing diagram of a program pulse according to the circuit of Figure 10;

Figure 12 shows another embodiment of the present invention;

Figure 13 shows a circuit having an EPROM operated by a single power source;

Figure 14 shows a timing diagram of clock pulses.

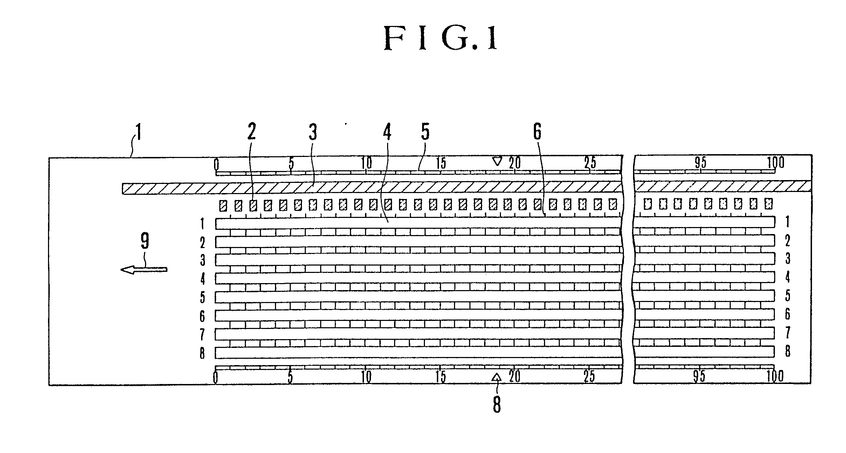

Referring to Figure 1, numeral 1 designates a transparent sheet, numeral 2 designates a plurality of write clock marks and 3 designates a read/write control line (R/W) for generating signals for writing and reading, the marks 2 and line 3 being printed in opaque ink. Numeral 4 designates a plurality of parallel data lines and 5 is a scale having one hundred indications. A plurality of indications 6 correspond to the scale 5.

Each indication 6 is in a central position between write clock marks 2, which aims to prevent any erroneous counting of data pulses. Numeral 8 is an index for positioning the sheet in a body of a sheet reading device and 9 is an arrow showing an insertion direction of the sheet.

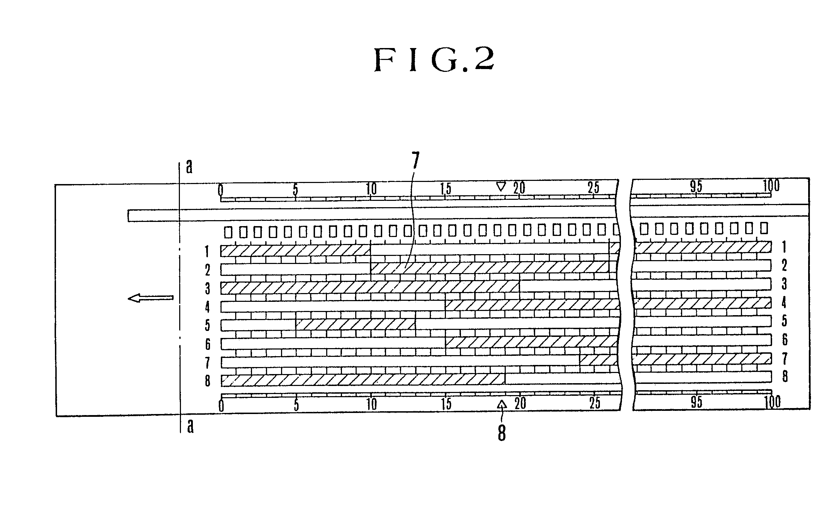

Figure 2 shows a sheet on which eight stepped time charts are provided by adhering opaque tapes to the sheet. A dotted line a—a is an operational start line when the sheet is inserted into a sheet reader device as described hereinafter.

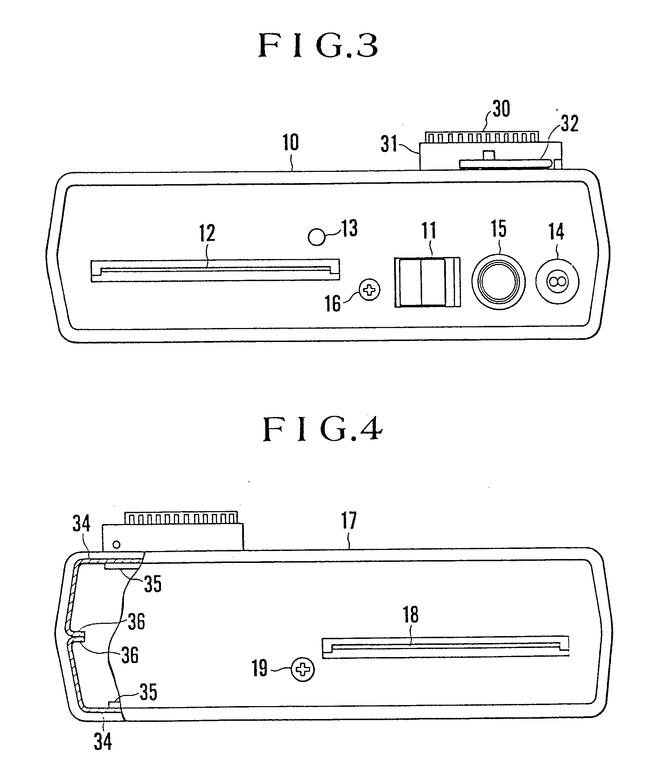

Figure 3 is a front view of a write-only sequence controller according to the present invention. Numeral 10 is a front panel, 11 is a power switch, 12 is a program sheet extracting slot, 13 is a pilot lamp, 14 is a supply cord, 15 is a fuse and 16 is a fastening screw.

Figure 4 is a back view of the write-only sequence controller. Numeral 17 is a back panel, 18 is a program sheet inserting slot and 19 is a fastening screw.

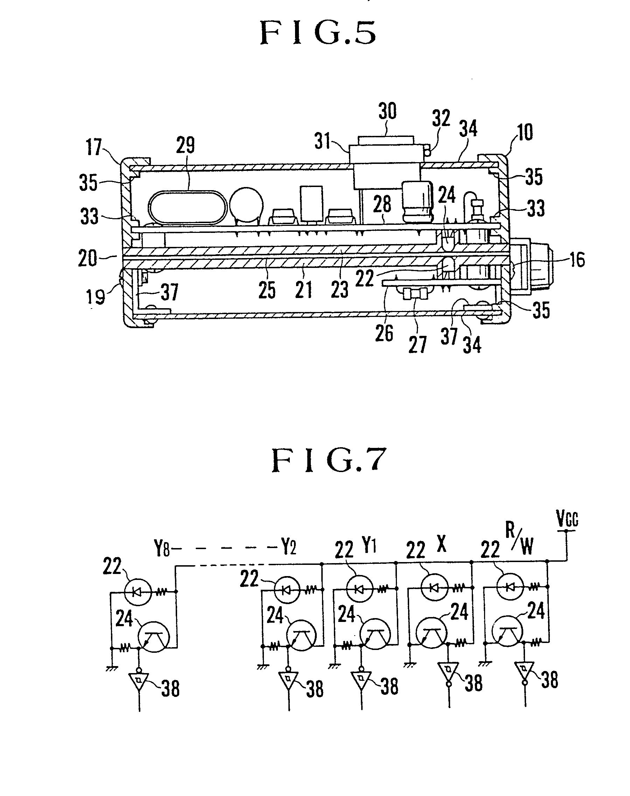

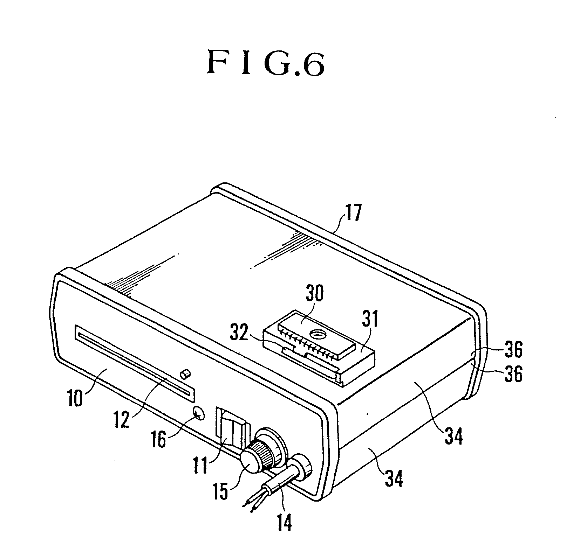

As shown in Figure 5, a sheet reader 20 comprises a light emitting panel 21 having a plurality of light emitting elements 22 and a light receiving panel having a plurality of light receiving elements 24 and both panels are engaged with a sliding inserting engagement so as to face one another and are supported in grooves provided in panels 10, 17 to form a gap 25 for passing the program sheet. A printed wiring board 26 is secured to the light emitting panel 21, on which a resistor 27 for light emitting elements 22 is provided. Secured to the light receiving board 23, is a printed-wiring board 28 on which a memory, a gate, a crystal oscillator 29, a capacitance, resistors and a connector 31 are provided. An EPROM 30 is detachably connected to the connector 31 and is detained in the connected position by a lock lever 32 (Figure 6).

As shown in Figure 5, a pair of supporting projections 33 for the board 28 and projections 35 for covers 34 are formed in panels 10 and 17. Opposite end portions of each cover 34 are outwardly inclined and bent at ends 36 to reinforce the portions. The covers are abutted at bend ends 36 and are supported between the supporting projections 35 and secured by L-shaped members 37 and screws 16 and 19.

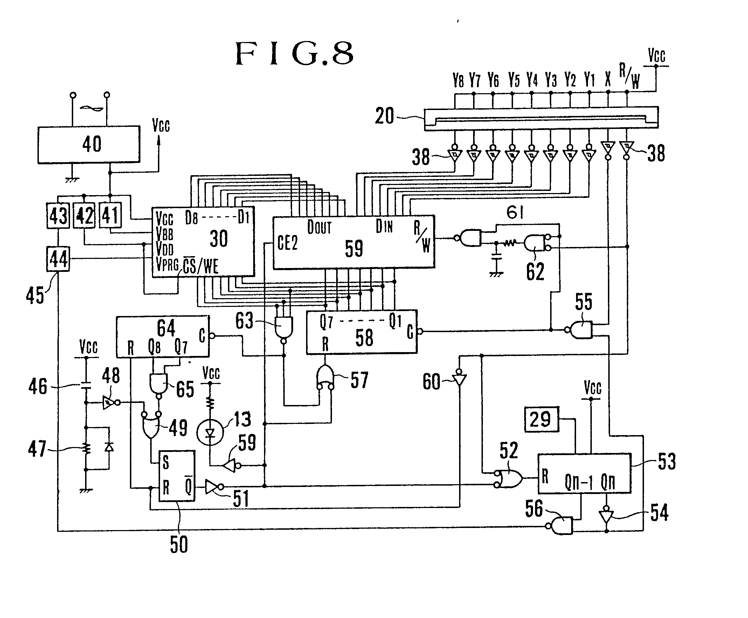

Referring to Figure 7, the photo-electric switch array comprises a photo-electric switch unit R/W corresponding to the R/W line 3 in Figure 1, photo-electric switch unit X corresponding to the write clock marks 2 and eight photo-electric switch units Y1, Y2 . . . Y8 corresponding to the data lines 4. The output of each photo-electric switch unit is shaped by a Schmitt trigger 38. A photo-transistor 24 of each of the photo-electric switch unit R/W and photo-electric switch unit X is turned off when the light from the light emitting diode 22 to the photo-transistor 24 is interrupted by an opaque portion of the program sheet 1, so that the output of the circuit goes to a 1 and the output of the Schmitt trigger 38 goes to a 0. The photo transistor opposite the transparent portion of the sheet is turned on so that the output of the Schmitt trigger 38 becomes a 1.

Each of the photo-transistors of photo-electric switch units Y1, Y2 . . . Y8 is an emitter follower.

Accordingly, the output of the Schmitt trigger 38 opposite an opaque portion is 1 and the output corresponding to a transparent portion is 0.

When the program sheet 1 is inserted into the device up to the indication 8, the light to the light emitting diodes is interrupted, so that the output of the photo-electric switch unit R/W becomes 1 and the output of the Schmitt trigger 38 becomes 0. Thus, the device is conditioned to one mode serving as a write-in mode in which data may be written into a ROM for the program sheet as described below.

When the program sheet is retracted and the photo-transistor 24 of the switch unit R/W again receives light, the output of the switch unit R/W goes to 0 and the output of the Schmitt trigger 38 goes to 1, so that the device is automatically changed to another mode serving as a transfer mode in which data written into the RAM is transferred to an EPROM as hereinafter described.

Referring to Figure 8, a system supply voltage $V_{CC}$ is obtained by an AC/DC converter 40 and energisation potentials $V_{BB}(-5V)$, $V_{DD}$ (+12V) and $V_{PRG}$ (+26V) are applied to an EPROM 30 from DC/DC converters 41, 42 and 43. The energisation potential $V_{PRG}$ is applied to the EPROM through a control circuit 44.

When a control pulse signal "1" is applied to the input 45 of the control circuit 44, an energisation potential $V_{PRG}$ pulse to the EPROM is cut off, and when the control pulse signal is 0, an energisation potential pulse $V_{PRG}$ is supplied to the $V_{PRG}$ terminal of the EPROM.

When the power switch 11 is turned on, the entire circuit is reset by a differentiation pulse from a differentiating circuit comprising a capacitance 46 and a resistor 47. More particularly, a differentiation pulse "1" is applied to a set input S of a flip-flop 50 through a 2-input NAND gate 49, so that the output $\overline{Q}$ goes to 1.

Thus;

A. Since 1 a is applied to a reset terminal R of a binary counter 53 through an inverter 51 and a 2-input NAND gate 52, all outputs of the binary counter 53 are 0's. (When reset R=0, the binary counter 53 divides the output of the crystal oscillator 29 to produce a read clock pulse train from Qn and the above described control pulses from Qn−1).

Therefore, the read clock pulse train and the control pulses are not generated when a 1 is applied to reset terminal R of the binary counter 53.

B. A 1 is applied to a reset terminal R of a binary counter 58 through a 2-input NAND gate 57 to clear the binary counter 58.

C. A 0 is applied to a chip-enable $CE_2$ of a RAM 59 to cause it to enter its non-selected state.

D. The program lamp 13 is turned off. Under such conditions, the EPROM 30 is inserted into the connector 31 and secured by the lock lever 32.

Although the auto-reset circuit of Figure 8 uses the differentiation pulse by the differentiating circuit, a differentiation pulse from an integrating circuit may alternatively be used.

Then, the program sheet 1 is inserted into the device from the opening 18 to the indication 8. The output of the photo-electric switch unit R/W is 0, which is the write-in mode. That is, a 1 is inputted to the reset terminal R of the flip-flop 50 through an inverter 60. Thus, the output of the inverter 51 changes to 1:

A. The output $CE_2$ of the RAM 59 changes to 1 to keep it in the selection state.

B. Inputs of a gate 57 are 1's and a reset R of the binary counter 58 is 0.

C. A 1 is inputted to a reset terminal R of the binary counter 53 through a gate 52, so that neither the read clock pulse train nor the control pulses are generated during the write-in mode.

D. The inputs of a NOR gate 62 of a differentiation pulse generating circuit 61 change to 0's, so that the gate is opened.

Thus, the device is conditioned into its write-in mode. The program sheet is then drawn through the device. One hundred clock pulses are inputted to the clock terminal C of the binary counter 58 through a gate 55 to address the corresponding address cells of the RAM 59 through address lines Q1, Q2 ... Q7. On the other hand, the output of the gate 55 is applied to an input R/W of the RAM 59 through the differentiation pulse generating circuit 61 in synchronism with the clock pulses. By the R/W signal, eight steps of data (Figure 2) from the photo-electric switch units are written into the memory cells of the RAM 59 which are addressed by the binary counter 58.

When one hundred clock pulses have been counted by binary counter 58, the output of a 3-input NAND gate 63 will go to 0. That is, since binary equivalent of one hundred decimal is 1100100, address lines Q3, Q6, Q7 are 1's, so that the output of the 3-input NAND gate 63 goes to 0. Thus, a 1 is inputted to the reset terminal R of the binary counter 58 through the gate 57 to clear the binary counter 58.

When the R/W line 3 of the program sheet 1 passes the operating line of the photo-electric switch unit R/W, the output of the switch unit R/W will go to 1 to convert the system from the first, write-in mode into the other, transfer mode in which data is transferred from the RAM to the EPROM. More particularly,

A. The output of the photo-electric switch unit X goes to 1 to thereby open the clock pulse control gate 55.

B. Since a 1 is inputted to the gate 62 of the differentiation pulse generating circuit 61, the R/W line of the RAM 59 is changed to 1 to close the data input $D_{IN}$ and to open the data output $D_{OUT}$.

C. The inputs of the gate 52 go to 1's and the reset R of the binary counter 53 goes to 0. Accordingly, read clock pulses are generated from the gate 55 and control pulses are generated from the gate 56.

The read clock pulses are inputted to the binary counter 58 through the gate 55, so that address cells in the RAM 59 and in the EPROM 30 corresponding to address lines Q1, Q2 . . . Q7 are addressed. Data having been previously written in the RAM 59 is transferred into address cells in the EPROM 30 in synchronism with the control pulses.

When the binary counter 58 counts one hundred clock pulses, the output of the gate 63 will go to 0. Thus, a binary counter 64 counts one. Since a 0 is applied to the gate 57, the binary counter 58 is cleared. Accordingly, the binary counter 58 counts again the read clock pulses. At every cycle end, the binary counter 64 counts one.

For example, in the case where the program loop number from the RAM 59 to the EPROM 30 is 384, the binary number of 384 is 11000000. In this case, two inputs of the 2-input NAND gate 65 are connected to terminals Q7, Q8 of the binary counter 64. By such connection, when the binary counter 64 counts 384 program loops, the output of the gate 65 will go to 0 which is inputted to the set input S of the flip-flop 50 through the gate 49.

Thus, the output $\overline{Q}$ of the flip-flop 50 goes to a 1:

A. The input of the gate 52 goes to 0 so that generation of the clock pulses and the control pulses is stopped.

B. The binary counter 58 is cleared.

C. The CE$_2$ of the RAM 59 goes to 0, so that the RAM 59 enters its non-selected state.

D. The pilot lamp 13 is turned off to indicate the completion of transfer of data from the RAM into the EPROM 30. Then the EPROM 30 is detached, from the connector 31 and is capable of subsequent electronic read-out by suitable reading apparatus to control a sequence of operations in accordance with the original data from the program sheet.

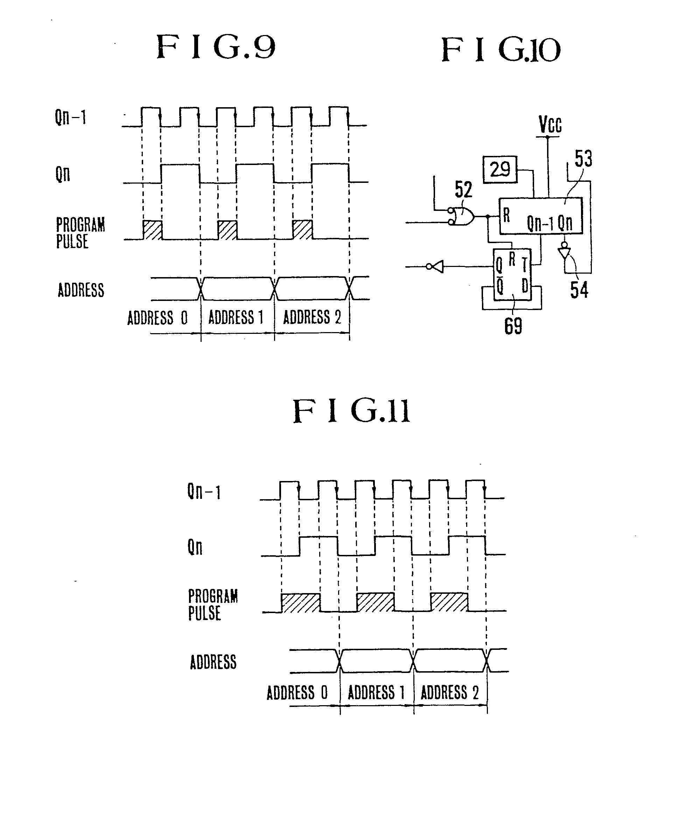

Figure 9 shows the timing diagram of the control pulse generating circuit. The control pulses (referred to as a program pulse in the drawing) as shown by the hatch lines are generated from the gate 56 in synchronism with the clock pulses Qn and with 1/4 cycle advance phase difference. Accordingly, data is written in the address 0 of the EPROM.

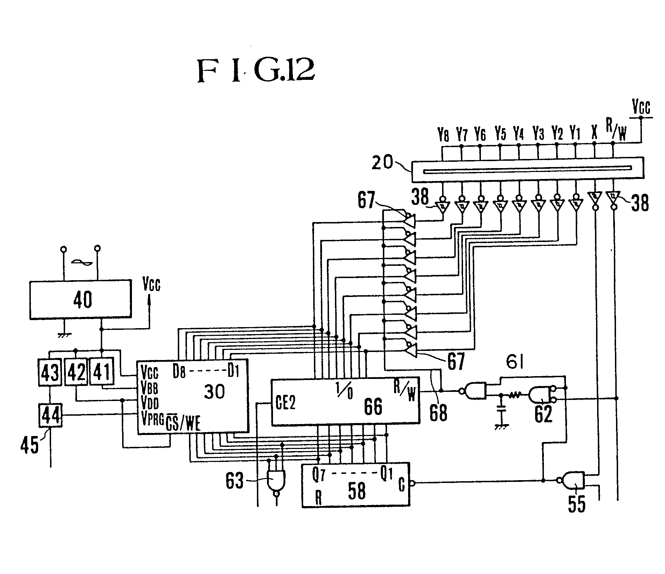

Figure 10 shows an example of the control pulse generating circuit using a type-D flip-flop, the timing diagram of which is shown in Figure 11. The output Qn−1 of the binary counter 53 is generated through the type-D flip-flop 69 in synchronism with the output Qn and with 1/4 cycle advance phase difference. As will be seen from Figure 11, the width of the control pulse therein·is twice as long as the control pulse of Figure 9. Therefore, the number of program loops necessary to write-in from the RAM to the EPROM is half as many as Figure 9 and hence the data transfer time is half.

Figure 12 shows an example in which a RAM 66 having a common input and output is used.

Input data buses are connected to the I/O lines of the RAM 66 through 3-state buffers 67 and output data buses are connected to data inputs D1, D2 . . . D8 of the EPROM 30. Each 3-state buffer 67 is controlled by a disable line 68. More particularly, when the disable line 68 is 1, the gate of the 3-state buffer 67 is closed and when the disable line 68 is 0, the gate of the 3-state buffer 67 is opened. Thus, in the write-in mode, data is written into memory cells in the RAM 66 through I/O lines in synchronism with the differentiation pulses synchronized with the write-in clock pulses. In the data transfer mode, since the R/W line of the RAM 66 is held to 1, the gate of the 3-state buffer 67 is closed. Data written in the RAM 66 is transferred into addressed cells of the EPROM 30 in synchronism with the control pulses.

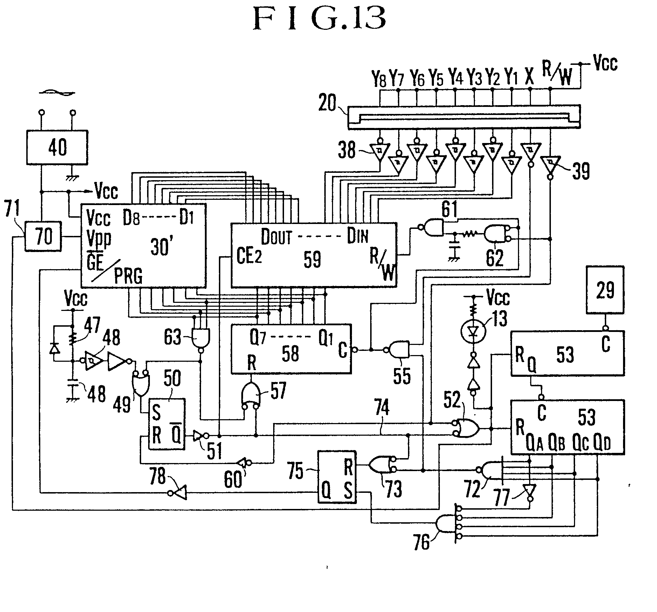

Figure 13 shows another example of write-only sequence controller according to the invention in which data is transferred from the RAM into a read-only memory EPROM 30′ operated by a single power source of +5v. The system power source V$_{cc}$ is obtained by an AC/DC converter and +25V is controllably supplied to V$_{pp}$ of the EPROM 30′ by a controlled DC/DC converter 70. When the input 71 of the converter 70 is 0, +25V is supplied to the V$_{pp}$ terminal, and when the input 71 is 1, the energisation potential to the EPROM is stopped.

In the EPROM 30′, a N-bit program is added at every addressing and the data transfer is completed in one loop. At that time, the width of the control pulse applied to the terminal CE/PRG is about 50ms per address.

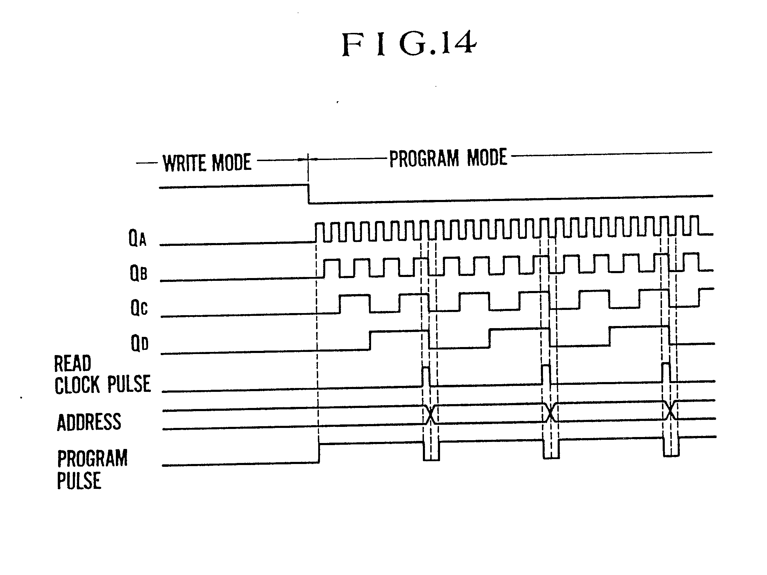

The frequency of the crystal oscillator 29 is selected so as to obtain the control pulse of 50ms. The frequency is divided by 2-stage binary counters 53 (not always two stages), divider outputs Q$_A$, Q$_B$, Q$_C$, and Q$_D$ of the binary counter are inputted to a 4-input NAND gate 72. In the write-in mode, the divider outputs are stopped, and in the data transfer mode, pulses are generated from the outputs Q$_A$, Q$_B$, Q$_C$, and Q$_D$. As shown in Figure 14, a read clock pulse is generated from the 4-input NAND gate 72 at every eight counts of Q$_A$.

The output of the gate 72 is connected to one of the inputs of a 2-input NAND gate 73 and a line 74 is connected to the other input of the 2-input NAND gate 73. The output of the gate 73 is applied to reset R of a flip-flop 75.

Also, divider outputs Q$_A$, Q$_B$, Q$_C$ and Q$_D$ are inputted to a 4-input NAND gate 76. The output Q$_A$ is connected to the gate 76 through an inverter 77. Therefore, during the period in which the divider outputs Q$_A$, Q$_B$, Q$_C$ and Q$_D$ change from 1111 to 1000, which is equal to one cycle of the output Q$_A$, the gate 76 produces output 0.

When the power is supplied, a differentiation pulse generated from an integrating circuit comprising the capacitance 46 and resistor 47 is applied to the flip-flop 50 through the Schmitt trigger 48 and the inverter 49 to reset all the circuits.

Then, when the program sheet is inserted into the sheet reader, the system is converted to the write-in mode. While the program sheet passes through the sheet reader, data is written into the RAM in synchronism with the write-in pulses.

When the program sheet has passed the sheet reader and the output of photo-electric switch unit R/W changes state, the system automatically changes to the data transfer mode. Since both inputs of the 2-input NAND gate 52 are 1's and the reset R of the binary counter 53 is 0, divider outputs $Q_A$, $Q_B$, $Q_C$ and $Q_D$ generate pulses. Read Clock pulses are produced from the gate 72, and control pulses are inputted to the terminal $\overline{CE}$/PRG of the EPROM through the gate 76, flip-flop 75 and inverter 78.

Read clock pulses are inputted to the binary counter 58 through the gate 55, so that address cells of the RAM 9 and EPROM 30' corresponding to address lines Q1, Q2 . . .Q7 are addressed. Data written in the RAM is thereby transferred into addressed memory cells of the EPROM 30' in synchronism with the control pulses.

When the binary counter counts one hundred read clock pulses, the output of the gate 63 will go to 0. Thus, a 1 is applied to the flip-flop 50 through the gate 49 to reset all the circuits.

Since the line 74 goes to 0, a 1 is applied to the reset terminal R of the flip-flop 75 through the gate 73. Thus, a 0 is inputted to the $\overline{CE}$/PRG terminal so that the EPROM may then be detached.

In the above described embodiments of write-only photo-electric sequence controllers according to the present invention as claimed, programming and modifying of data may be easily carried out. By inserting the program sheet into the controller and extracting the sheet from it, a plurality of data may be written in the EPROM. The controller may be made as a light-weight device, for example 450 grams and into a compact size. Thus, the controller is contributory to the automating and energy saving for machines and apparatus across a wide industrial field.

**Claims**

1. Apparatus operable to convert a physical representation of sequence control data from the form of a marked program sheet into the form of an electronic memory having said data written therein and capable of subsequent electronic read-out to control a sequence of operations, said apparatus comprising:
a sheet reading device (20) capable of reading an elongate transparent program sheet (1) movable in said device and bearing a series of write clock marks (2), a plurality of data lines (4) and a read/write control line (3) which are formed of opaque material and are arranged in the longitudinal direction of said sheet;
said sheet reading device (20) comprising:
means (12, 18, 25) for passing said sheet along a path in the device;
a plurality of light-emitting elements (22) disposed in the direction lateral to the direction of movement of the sheet at the entrance of said path;
a plurality of light-receiving elements (24) each of which corresponds to a respective one of the light-emitting elements (22) and arranged to generate write clock pulses, data outputs and a read/write signal when light from the corresponding light emitting element (22X, 22Y, 22R/W) is interrupted by the respective write clock marks, data lines and read/write control line;
a RAM (59) for memorising said data in synchronism with said write clock pulses;
a first binary counter (58) for counting said write clock pulses and for addressing said RAM (59);
a second binary counter (53) for generating read clock pulses in response to pulses from an oscillator (29);
first gate means (62) responsive to one mode of said read/write signal to condition said RAM into its write-in state and responsive to the other mode of said read/write signal to change the condition of said RAM into its read-out state;
second gate means (50, 51, 52, 57) responsive to said one mode of said read/write signal effective to enable the first binary counter (58) and to inhibit said second binary counter (53) and to condition said RAM into an enable state; and
third gate means (63) for generating a signal for stopping the sheet reading operation when the count of said first binary counter (58) reaches a predetermined number;
whereby data carried by said program sheet is written into said RAM (59) while the read/write signal is in said one mode during passage of the program sheet (1) through said sheet reading device (20);
characterised by:
a connector (31) for detachably connecting an EPROM (30) to said apparatus, said connector (31) having terminals (D) for electrically connecting said EPROM to said RAM (59) to permit transfer of said written-in data from said RAM into said connected EPROM;
means (44) for controlling energisation of a said connected EPROM to permit the EPROM to memorise data read out from said RAM;
said first binary counter (58) being adapted also to address a said connected EPROM;
said second binary counter (53) being adapted also to generate control pulses, in response to pulses from said oscillator (29), for controlling acceptance by said EPROM of data transferring thereto upon read-out from said RAM in response to said read clock pulses; and
said second gate means (50, 51, 52, 57) also being responsive to said other mode of said read/write signal to enable said second binary counter (53) to generate said read clock pulses and said control pulses;
whereby sequence control data written into said RAM from said program sheet is automatically transferred into said connected EPROM when the read/write signal changes from said one mode to said other mode.

2. Apparatus according to claim 1 characterised in that output signals of said light-receiving elements (24) are connected to an input/output bus line (I/O) of said RAM (66) and also to data input bus lines of said EPROM (30) through a 3-state buffer (67), and the output of a differentiation pulse generating circuit (61) is connected to a read/write control line (R/W) of said RAM (66) and to a disable line (68) for controlling the 3-state buffer (67).

3. Apparatus according to claim 1 or claim 2 characterised in that said sheet reader (20) comprises a first panel (21) carrying said plurality of light emitting elements (22) and a second panel (23) carrying said plurality of light receiving elements (24), both said panels being provided with printed-wiring boards and being engaged with a sliding insertion engagement in the reader so as to face each other to form a gap (25) for passage of the program sheet (1).

4. Apparatus according to claim 1 characterised by means for supplying energisation potentials ($V_{CC}$, $V_{BB}$, $V_{DD}$, $V_{PRG}$) for said EPROM (30) from a supply voltage and a switched regulator system, a plurality of said potentials ($V_{CC}$, $V_{BB}$, $V_{DD}$) being directly applied to corresponding terminals of said EPROM (30), and one said potential ($V_{PRG}$) being controllably applied to said EPROM through said control means (44), and by means for applying said control pulses generated by said second binary counter (53) to said control means (44) to control said application of said one potential ($V_{PRG}$) to said EPROM in synchronism with said read clock pulses and in advance thereof.

5. Apparatus according to claim 1 characterised in that said second binary counter (53) has divider outputs ($Q_A$, $Q_B$, $Q_C$, and $Q_D$) which are connected as inputs to a gate (72), said gate (72) having an output connected to the first input of a 2-input NAND gate (73), the output line (74) of an inverter (51) is connected to the second input of the 2-input NAND gate (73), the output of the 2-input NAND gate (73) is connected to the reset terminal of a flip-flop (75), a plurality of said divider outputs ($Q_B$, $Q_C$, $Q_D$) are connected to a further gate (76), a remaining said divider output ($Q_A$) is connected to said further gate (76) through a further inverter (77), the output of the further gate (76) is applied to an input ($\overline{CE}$/PRG) of said EPROM (30') through the flip-flop (75) whereby to permit the EPROM to memorise data read out from said RAM (59), a clock pulse is supplied from the gate (72) to said first binary counter (58) through another gate (55) in said other mode of said read/write signal so that said RAM (59) and said EPROM (30') are addressed by corresponding address lines, and the control pulses are applied to the input ($\overline{CE}$/PRG) of the EPROM through the further gate (76) and the flip-flop (75) for transferring the data written in the RAM to the EPROM.

6. Apparatus according to claim 1 characterised in that a control input of a DC/DC converter (70) is connected to an output of a gate (52) for controlling said second binary counter (53), a signal 0 is inputted to the DC/DC converter (70) during said other mode for supplying an energisation potential to a terminal ($V_{pp}$) of said EPROM (30'), and a signal 1 is inputted to the DC/DC converter (70) during said one mode and after data transfer from the RAM to the EPROM for cutting the energisation potential to said terminal ($V_{pp}$) of the EPROM (30').

**Revendications**

1. Appareil propre à convertir une représentation physique de données de contrôle de séquence depuis la forme d'une feuille de programmation marquée à la forme d'une mémoire électronique contenant les données enregistrées et se prêtant à une lecture électronique ultérieure pour contrôler une séquence d'opérations, cet appareil comprenant:

un dispositif de lecture de feuille (20) à même de lire une longue feuille de programmation transparente (1) mobile dans le dispositif et portant une série de marques de synchronisation d'enregistrement (2), plusieurs lignes de données (4) et une ligne de commande de lecture/enregistrement (3) qui sont faites d'une matière opaque et qui sont disposées dans le sens longitudinal de la feuille;

le dispositif lecteur de feuille (20) comprenant:

des moyens (12, 18, 25) pour faire passer la feuille suivant un trajet dans le dispositif;

plusieurs éléments émettant de la lumière (22) disposés dans le sens latéral par rapport à la direction dans laquelle la feuille se déplace à l'entrée du dit trajet;

plusieurs éléments recevant de la lumière (24) qui correspondant chacun à une élément émettant de la lumière (22) respectif et qui sont destinés à produire des impulsions de synchronisation d'enregistrement, des sorties de données et un signal de lecture/enregistrement lorsque de la lumière provenant de l'élément émettant de la lumière correspondant (22X, 22Y, 22R/W) est interrompue par les marques de synchronisation d'enregistrement, les lignes de données et la ligne de commande de lecture/enregistrement respectives;

une mémoire RAM (59) pour mémoriser les données en synchronisme avec les impulsions de synchronisation d'enregistrement;

un premier compteur binaire (58) pour compter les impulsions de synchronisation d'enregistrement et pour adresser la mémoire RAM (59);

un second compteur binaire (53) pour produire des impulsions de synchronisation de lecture en réaction à des impulsions provenant d'un oscillateur (29);

un premier circuit-porte (62) réagissant à un mode du signal de lecture/enregistrement afin de conditionner la mémoire RAM dans son état d'enregistrement et réagissant à l'autre mode du signal de lecture/enregistrement pour changer le conditionnement de la mémoire RAM pour la faire passer dans son état de lecture;

un deuxième circuit-porte (50, 51, 52, 57) réagissant au premier mode du signal de lecture/enregistrement, à même d'activer le premier compteur binaire (58), de désactiver le second compteur binaire (53) et de conditionner la mémoire RA dans un état de validation, et

un troisième circuit-porte (63) pour produire un signal destiné à arrêter l'opération de lecture de la feuille lorsque le compte du premier compteur binaire (58) atteint un nombre prédéterminé;

des données supportées par la feuille de programmation étant enregistrées dans la mèmoire RAM (59) tandis que le signal de lecture/enregistrement se trouve dans le premier mode pendant le passage de la feuille de programmation (1) à travers le dispositif de lecture de feuille (20);

caractérisé par:

un connecteur (31) pour connecter de manière détachable une mémoire EPROM (mémoire morte programmable électriquement) à l'appareil, le connecteur comportant des bornes (D) pour connecter électriquement la mémoire EPROM à la mémoire RAM (59) en vue de permettre le transfert des données enregistrées de la mémoire RAM dans la mémoire EPROM connectée;

un moyen (44) pour commander l'excitation d'une mémoire EPROM connectée en vue de permettre à cette mémoire EPROM de mémoriser des données sorties par lecture de la mémoire RAM;

le premier compteur binaire (58) étant aussi à même d'adresser une mémoire EPROM connectée;

le second compteur binaire (53) étant aussi à même de produire des impulsions de contrôle en réaction aux impulsions provenant de l'oscillateur (29) pour contrôler l'acceptation par la mémoire EPROM des données qui y sont transférées lors de l'extraction de la mémoire RAM en réaction aux impulsions de synchronisation de lecture, et

le second circuite-porte (50, 51, 52, 57) réagissant également à l'autre mode du signal de lecture/enregistrement afin de permettre au second compteur binaire (53) de produire les impulsions de synchronisation de lecture et les impulsions de contrôle;

des données de contrôle de séquence enregistrées dans la mémoire RAM à partir de la feuille de programmation étant transférées automatiquement dans la mémoire EPROM connectée lorsque le signal de lecture/enregistrement passe du premier mode à l'autre mode.

2. Appareil suivant la revendication 1, caractérisé en ce que des signaux de sortie des éléments recevant de la lumière (24) sont connectés à une ligne de bus d'entrée/sortie (E/S) de la mémoire RAM (66) ainsi qu'à des lignes de bus d'entrée de données de la mémoire EPROM (30) par l'intermédiaire d'un tampon à trois états (67) et la sortie d'un circuit générateur d'impulsions de différenciation (61) est connectée à une ligne de commande de lecture/enregistrement de la mémoire RAM (66) et à une ligne d'invalidation (68) pour commander le tampon à trois états (67).

3. Appareil suivant la revendication 1 ou 2, caractérisé en ce que le lecteur de feuille (20) comprend un premier panneau (21) portant les divers éléments émettant de la lumière (22) et un second panneau (23) portant les divers éléments recevant de la lumière (24), les deux panneaux étant pourvus de plaques à circuit imprimé et étant engagés avec un engagement par insertion à glissement dans le lecteur de manière à se faire face et à délimiter un interstice (25) pour le passage de la feuille de programmation (1).

4. Appareil suivant la revendication 1, caractérisé par un dispositif pour fournir des tensions d'excitation ($V_{CC}$, $V_{BB}$, $V_{DD}$, $V_{PRG}$) pour la mémoire EPROM (30) à partir d'une tension d'alimentation et d'un système de régulateur commuté, plusieurs de ces tensions ($V_{CC}$, $V_{BB}$, $V_{DD}$) étant directement appliquées à des bornes correspondantes de la mémoire EPROM (30) et une de ces tensions ($V_{PRG}$) étant appliquée de façon contrôlable à la mémoire EPROM par l'intermédiaire du moyen de contrôle (44) et par un moyen pour appliquer les impulsions de contrôle produites par le second compteur binaire (53) au moyen de contrôle (44) en vue de contrôler l'application de la première tension ($V_{PRG}$) à la mémoire EPROM en synchronisme avec les impulsions de synchronisation de lecture et en avance sur celles-ci.

5. Appareil suivant la revendication 1, caractérisé en ce que le second compteur binaire (53) comporte des sorties de diviseur ($Q_A$, $Q_B$, $Q_C$ et $Q_D$) qui sont connectées en tant qu'entrées à un circuit-porte (72), le circuite-porte (72) comportant une sortie connectée à la première entrée d'un circuit-porte NON ET à deux entrées (73), la ligne de sortie (74) d'un inverseur (51) est connectée à la seconde entrée du circuit-porte NON ET à deux entrées (73), la sortie du circuit-porte NON ET à deux entrées (73) est connectée à la borne de repositionnement d'un bascule (75), plusieurs sorties de diviseur ($Q_B$, $Q_C$, $Q_D$), sont connectées à un autre circuit-porte (76), une sortie de diviseur restante ($Q_A$) est connectée à l'autre circuit-porte (76) par l'intermédiaire d'un autre inverseur (77), la sortie de l'autre circuit-porte (76) est appliquée à une entrée ($\overline{CE}$/PRG) de la mémoire EPROM (30') par l'intermédiaire de la bascule (75) de manière à permettre à la mémoire EPROM de mémoriser des données extraites de la mémoire RAM (59), une impulsion de synchronisation est fournie à partir du circuit-porte (72) au premier compteur binaire (58) par l'intermédiaire d'un autre circuit-porte (55) dans l'autre mode du signal de lecture/écroture, de telle sorte que la mémoire RAM (59) et la mémoire EPROM (30') sont adressées par des lignes d'adresses correspondantes, et les impulsions de contrôle sont appliquées à l'entrée ($\overline{CE}$/PRG) de la mémoire EPROM par l'intermédiaire de l'autre circuit-porte 76 et de la bascule (75) pour transférer les données enregistrées dans la mémoire RAM à la mémoire EPROM.

6. Appareil suivant la revendication 1, caractérisé en ce qu'une entrée de commande d'un convertisseur CC/CC (70) est connectée à une sortie d'un circuit-porte (52) pour commander le second compteur binaire (53), un signal 0 est introduit dans le convertisseur CC/CC (70) pendant cet autre mode afin de fournir une tension d'excitation à une borne (V$_{pp}$)mde la mémoire EPROM (30') et un signal 1 est introduit dans le convertisseur CC/CC (70) pendant le premier mode et après le transfert des données de la mémoire RAM à la mémoire EPROM pour couper la tension d'excitation à la borne (V$_{pp}$) de la mémoire EPROM (30').

## Patentansprüche

1. Einrichtung zur Umwandlung einer physikalischen Darstellung von Folgesteuerungsdaten von der Form eines markierten Programmblatts in die Form eines elektronischen Speichers mit diesen darin eingeschriebenen und nachfolgend elektronisch zur Steuerung einer Folge von Operationen auslesbaren Daten, wobei diese Einrichtung folgendes umfasst:

eine Blattlesevorrichtung (20), die ein längliches lichtdurchlässiges Programmblatt (1) lesen kann, das in besagter Vorrichtung bewegbar ist und eine Reihe Schreibtaktmarken (2), eine Mehrzahl Datenzeilen (4) une eine Schreib-/Lese-Steuerzeile (3) trägt, die aus lichtundurchlässigem Material gebildet und in Längsrichtung des besagten Blatts angeordnet sind;

wobei die besagte Blattlesevorrichtung (20) folgendes umfasst:

Mittel (12, 18, 25) zum Führen des besagten Blatts entlang eines Wegs in der Vorrichtung;

eine Mehrzahl lichtemittierender, in seitlicher Richtung zur Bewegungsrichtung des Blatts am Eingang des besagten Wegs angeordneter Elemente (22);

eine Mehrzahl lichtaufnehmenden Elemente (24), die jeweils einem entsprechenden der lichtemittierenden Elemente (22) entsprechen und so angeordnet sind, dass sie Schreibtaktimpulse, Datenausgaben und ein Schreib-/Lese-Signal generieren, wenn Licht von dem entsprechenden lichtemittierenden Element (22X, 22Y, 22R/W) durch die entsprechenden Schreibtaktmarken, Datenzeilen und Schreib-/Lese-Steuerzeile unterbrochen wird;

eine RAM (59) zum Speichern der besagten Daten im Gleichtakt mit den besagten Schreibtaktimpulsen;

einen ersten Binärzähler (58) zum Zählen der besagten Schreibtaktimpulse und zum Adressieren des besagten RAM (59);

einen zweiten Binärzähler (53) zum Generieren von Lesetaktimpulsen als Reaktion auf Impulse von einem Oszillator (29);

erste Gattermittel (62), die zur Konditionierung des besagten RAM in seinen Einschreibezustand auf einen Modus des besagten Schreib-/Lese-Signals und zur Aenderung des Zustands des besagten RAM in seinen Auslesezustand auf den anderen Modus des besagten Schreib-/Lese-Signals ansprechen;

zweite Gattermittel (50, 51, 52, 57), die auf jenen Modus des besagten Schreib-/Lese-Signals dahingehend ansprechen, dass der erste Binärzähler (58) freigegeben und der besagte zweite Binärzähler (53) blockiert wird und der besage RAM in einen Freigabezustand konditioniert wird; und

dritte Gattermittel (63) zum Generieren eines Signals zum Stoppen der Blattleseoperation, wenn der Zählerstand des besagten ersten Binärzählers (58) eine vorbestimmte Zahl erreicht;

wodurch vom besagten Programmblatt getragene Daten in den besagten RAM (59) eingeschrieben werden, während sich das Schreib-/Lese-Signal während des Durchlaufens des Programmblatts (1) durch die besagte Blattlesevorrichtung (20) in dem besagten einen Modus befindet;

gekennzeichnet durch:

einen Steckverbinder (31) zum ablösbaren Anschliessen eines EPROM (30) an die besagte Einrichtung, wobei der besagte Steckverbinder (31) mit Klemmen (D) zum elektrischen Anschliessen des besagten EPROM an den besagten RAM (59) versehen ist, um die Uebertragung der besagten eingeschriebenen Daten vom besagten RAM in dem besagten angeschlossenen EPROM zu gestatten;

Mittel (44) zum Steuern der Energiezuführung zu einem besagten angeschlossenen EPROM, damit der EPROM aus dem besagten RAM au-gelesene Daten speichern kann;

wobei durch den besagten ersten Binärzähler (58) auch ein besagter angeschlossener EPROM adressierbar ist;

wobei durch jenen zweiten Binärzähler (53) als Reaktion auf Impulse von besagten Oszillator (29) auch Steuerimpulse generierbar sind zum Steuern der Annahme durch den besagten EPROM von beim Auslesen vom besagten RAM als Reaktion auf die besagten Lesetaktimpulse auf ihn übertragenen Daten; und

wobei die besagten zweiten Gattermittel (50, 51, 52, 57) auch auf den besagten anderen Modus des besagten Schreib-/Lese-Signals reagieren, um den besagten zweiten Binärzähler (53) zur Generierung der besagten Lesetaktimpulse und der besagten Steuerimpulse freizugeben;

wodurch in den besagten RAM vom besagten Programmblatt eingeschriebene Folgesteuer-ungsdaten automatisch bei Wechsel des Screib-/Lese-Signals vom besagten einen Modus zum besagten anderen Modus in den besagten angeschlossenen EPROM übertragen werden.

2. Einrichtung nach Anspruch 1, dadurch gekennzeichnet, dass Ausgangssignale der besagten lichtaufnehmenden Elemente (24) über einen Puffer (67) mit drei Ausgangszuständen mit einer Eingangs-/Ausgangs-Busleitung (I/O) des besagten RAM (66) und auch mit Dateneingangs-Busleitungen des besagten EPROM (30) verbunden sind, und der Ausgang einer einen Differenzierungsimpuls erzeugenden Schaltung (61) mit einer Schreib-/Lese-Steuerungsleitung (R/W) des besagten RAM (66) und mit einer Sperrleitung (68) zum Steuern des Puffers (67) mit drei Ausgangszuständen verbunden ist.

3. Einrichtung nach Anspruch 1 oder Anspruch 2, dadurch gekennzeichnet, dass der besagte Blattleser (20) eine erste, die besagte Mehrzahl lichtemittierender Elemente (22) tragende Platte (21) und eine zweite, die besagte Mehrzahl von lichtaufnehmenden Elementen (24) tragende Platte (23) umfasst, wobei diese beiden Platten mit gedruckten Schaltkarten versehen sind und mit gleitendem Einschubeingriff so in den Leser eingerückt sind, dass sie einander gegenüberliegen, um einen Spalt (25) für den Durchlauf des Programmblatts (1) zu bilden.

4. Einrichtung nach Anspruch 1, gekennzeichnet durch Mittel für die Zuführung von Energieversorgungspotentialen ($V_{CC}$, $V_{BB}$, $V_{DD}$, $V_{PRG}$) für den besagten EPROM (30) von einer Versorgungsspannung und einer Schaltregleranlage, wobei eine Mehrzahl der besagten Potentiale ($V_{CC}$, $V_{BB}$, $V_{DD}$) direkt an entsprechende Anschlüsse des besagten EPROM (30) angeleft werden und ein solches Potential ($V_{PRG}$) steuerbar über das besagte Steuermittel (44) an den besagten EPROM angelegt wird, und durch Mittel zum Anlegen dieser durch den besagten zweiten Binärzähler (53) erzeugten Steuerimpulse an das besagte Steuermittel (44) zum Steuern des besagten Anlegens jenes einen solchen Potentials ($V_{PRG}$) an den besagten EPROM im Gleichtakt mit den besagten Lesetaktimpulsen und diesen voranlaufend.

5. Einrichtung nach Anspruch 1, dadurch gekennzeichnet, dass der besagte zweite Binärzähler (53) Teilerausgänge ($Q_A$, $Q_B$, $Q_C$, und $Q_D$) besitzt, die als Eingänge mit einem Gatter (72) verbunden sind, wobei das besagte Gatter (72) mit einem Ausgang mit dem ersten Eingang eines NAND-Gatters (73) mit zwei Eingängen verbunden ist, die Ausgangsleitung (74) einer Negationsschaltung (51) mit dem zweiten Eingang des NAND-Gatters (73) mit zwei Eingängen verbunden ist, der Ausgang des NAND-Gatters (73) mit zwei Eingängen mit dem Rücksetzanschluss eines Flip-flops (75) verbunden ist, eine Mehrzahl der besagten Teilerausgänge ($Q_B$, $Q_C$, $Q_D$) mit einem weiteren Gatter (76) verbunden sind, ein verbleibender besagter Teilerausgang ($Q_A$) über eine weitere Negationsschaltung (77) mit dem besagten weiteren Gatter (76) verbunden ist, die Ausgabe des weiteren Gatters (76) über den Flipflop (75) an einen Eingang ($\overline{CE}$/PRG) des besagten EPROM (30') angelegt ist, womit dem EPROM ermöglicht wird, aus dem besagten RAM (59) ausgelesene Daten zu speichern, ein Taktimpuls vom Gatter (72) über ein weiteres Gatter (55) im besagten anderen Modus des besagten Schreib-/Lese-Signals dem besagten ersten Binärzähler (58) zugeführt wird, so dass der besagte RAM (59) und der besagte EPROM (30') durch entsprechende Adressleitungen adressiert werden, und die Steuerimpulse über das weitere Gatter (76) und den Flipflop (75) and den Eingang ($\overline{CE}$/PRG) des EPROM angelegt werden, um die in den RAM eingeschriebenen Daten zum EPROM zu überführen.

6. Einrichtung nach Anspruch 1, dadurch gekennzeichnet dass ein Steuereingang eines Gleichspannungswandlers (70) zum Steuern des besagten zweiten Binärzählers (53) an einen Ausgang eines Gatters (52) angeschlossen ist, während des besagten anderen Modus dem Gleichspannungswandler (70) ein O-Signal eingegeben wird, um einem Anschluss ($V_{PP}$) des besagten EPROM (30') ein Energieversorgungspotential zuzuführen, und während des besagten einen Modus und nach Datenübertragung vom RAM zum EPROM dem Gleichspannungswandler (70) ein 1-Signal eingegeben wird, um das Energieversorgungspotential zum besagten Anschluss ($V_{pp}$) des EPROM (30') zu sperren.

# F I G.1

0 024 436

# FIG.2

# F I G.3

# F I G.4

# F I G.5

# F I G.7

# F I G.6

FIG.8

# F I G.9

Qn-1

Qn

PROGRAM
PULSE

ADDRESS

| ADDRESS 0 | ADDRESS 1 | ADDRESS 2 |

# F I G.10

Vcc

52

29

53

R    Qn-1 Qn

54

Q  R  T
Q̄     D

69

# F I G.11

Qn-1

Qn

PROGRAM
PULSE

ADDRESS

| ADDRESS 0 | ADDRESS 1 | ADDRESS 2 |

7

# F I G.12

# F I G.13

# F I G.14